(19) Europäisches Patentamt
European Patent Office
Office européen des brevets

(11) **EP 4 455 786 A1**

(12) **EUROPEAN PATENT APPLICATION**

(43) Date of publication:
**30.10.2024 Bulletin 2024/44**

(51) International Patent Classification (IPC):
**G03F 7/00** (2006.01)

(21) Application number: **23170059.2**

(52) Cooperative Patent Classification (CPC):
**G03F 7/70633; G03F 7/706837**

(22) Date of filing: **26.04.2023**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
- **ZACCA, Vincenzo, Giuseppe**
  **Veldhoven (NL)**
- **ZWIER, Olger, Victor**
  **Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND APPARATUS AND COMPUTER PROGRAM  BACKGROUND**

(57) Disclosed is a method of metrology, comprising: obtaining metrology data relating to one or more targets on a substrate, the metrology data comprising intensity metric data relating to one or more intensity metrics, and phase difference metric data relating to a phase difference metric; determining intensity asymmetry metric data from said intensity metric data, said intensity asymmetry metric data describing, for each said intensity metric, an asymmetry in said intensity metric data between diffraction orders of a complementary pair of diffraction orders following diffraction by said one or more targets; obtaining one or more pre-calibrated asymmetry coefficients; and determining a value for a parameter of interest from said phase difference metric data, and said intensity asymmetry metric data as weighted by said pre-calibrated asymmetry coefficients.

Fig. 6

**Description**

BACKGROUND

FIELD OF THE INVENTION

The present invention relates to methods and apparatus for metrology usable, for example, in the manufacture of devices by lithographic techniques and to methods of manufacturing devices using lithographic techniques.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., $40\mu m$ by $40\mu m$, gratings and the measurement beam generates a spot that is smaller than the grating (i.e., the grating is underfilled). This simplifies mathematical reconstruction of the target as it can be regarded as infinite. However, in order to reduce the size of the targets, e.g., to $10\mu m$ by $10\mu m$ or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242940A. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In the known metrology technique, overlay measurement results are obtained by measuring the target twice under certain conditions, while either rotating the target or changing the illumination mode or imaging mode to obtain separately the -1st and the +1st diffraction order intensities. The intensity asymmetry, a comparison of these diffraction order intensities, for a given target provides a measurement of target asymmetry, that is asymmetry in the target. This asymmetry in the target can be used as an indicator of overlay (undesired misalignment of two layers). Another known method measures a phase difference between dark-field images of two different types of sub-target.

Although the known dark-field image-based overlay measurements are fast and computationally very simple (once calibrated), they may rely on an assumption that layer misalignment (i.e., overlay error and/or deliberate bias where applicable) is the only cause of measured intensity asymmetry or phase difference. Any other contributions to measured intensity asymmetry or phase difference, such as any process effect within one or both of the overlaid gratings, also causes a contribution to the measured asymmetry The intensity asymmetry/phase difference contribution attributable to process effect, and which is not related to overlay, clearly perturbs the overlay measurement, giving an inaccurate overlay measurement. A similar issue occurs with alignment measurements due to asymmetries in the alignment targets or marks measured. Asymmetry in the lowermost or bottom grating of a target is a common form of process effect. It may originate for example in wafer processing steps such as chemical-mechanical polishing (CMP), performed after the bottom grating was originally formed.

It is therefore desirable to improve the accuracy of overlay and/or alignment measurements.

SUMMARY

In a first aspect of the invention there is provided a method of metrology, comprising: obtaining metrology data relating to one or more targets on a substrate, the metrology data comprising intensity metric data relating to one or more intensity metrics, and phase difference metric data relating to a phase difference metric; determining intensity asymmetry metric data from said intensity metric data, said intensity asymmetry metric data describing, for each said intensity metric, an asymmetry in said intensity metric data between diffraction orders of a complementary pair of diffraction orders following diffraction by said one or more targets; obtaining one or more pre-calibrated asymmetry coefficients; and determining a value for a parameter of interest from said phase difference metric data, and said intensity asymmetry metric data as weighted by said pre-calibrated asymmetry coefficients.

In a second aspect of the invention there is provided a method of calibrating a plurality of asymmetry coefficients, each said asymmetry coefficient relating to a respective intensity metric, the method comprising: obtaining calibration metrology data relating to a plurality of targets on at least one calibration substrate, the calibration metrology data comprising intensity metric data relating to said intensity metrics, and uncorrected parameter of interest data; determining calibration intensity asymmetry metric data from said intensity metric data, said calibration intensity asymmetry metric data describing, for each said intensity metric, an asymmetry in said intensity metric data between diffraction orders of a complementary pair of diffraction orders following diffraction by said targets; obtaining reference data relating to said parameter of interest; and optimizing said asymmetry coefficients so as to minimize a difference between said reference data and said uncorrected parameter of interest data when corrected with a combination of said calibration intensity asymmetry metric data and said asymmetry coefficients.

In another aspect a computer program comprising processor readable instructions which, when run on suitable processor controlled apparatus, cause the processor controlled apparatus to perform the method of the first or second aspect and a computer program carrier comprising such a computer program. The processor controlled apparatus may comprise a metrology apparatus or lithographic apparatus or processor therefor.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3(a) comprises a schematic diagram of a dark field scatterometer for use in measuring targets according to embodiments of the invention using a first pair of illumination apertures; Figure 3(b) illustrates a detail of diffraction spectrum of a target grating for a given direction of illumination; Figure 3(c) illustrates a second pair of illumination apertures providing further illumination modes in using the scatterometer for diffraction based overlay measurements; and Figure 3(d) illustrates a third pair of illumination apertures combining the first and second pair of apertures;
Figure 4 depicts a known form of multiple grating target and an outline of a measurement spot on a substrate;
Figure 5 is a flowchart of a calibration method for calibrating correction coefficients according to an embodiment;
Figure 6 illustrates an image which may be obtained from a measurement of the target of Figure 4, and an associated intensity signal; and
Figure 7 is a flowchart of a metrology method according to an embodiment.

DETAILED DESCRIPTION OF EXEMPLARY EMBODIMENTS

Before describing embodiments of the invention in detail, it is instructive to present an example environment in which embodiments of the present invention may be implemented.

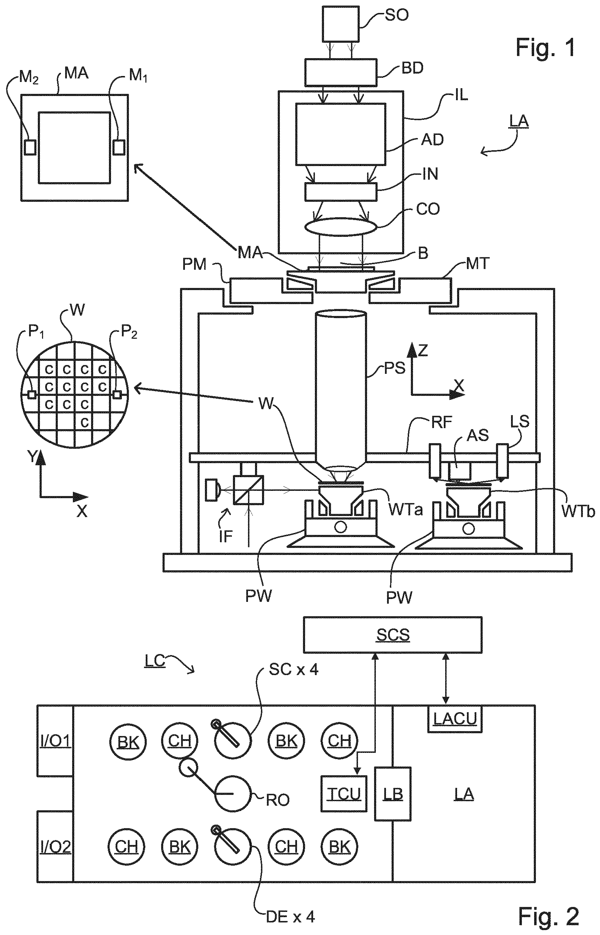

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

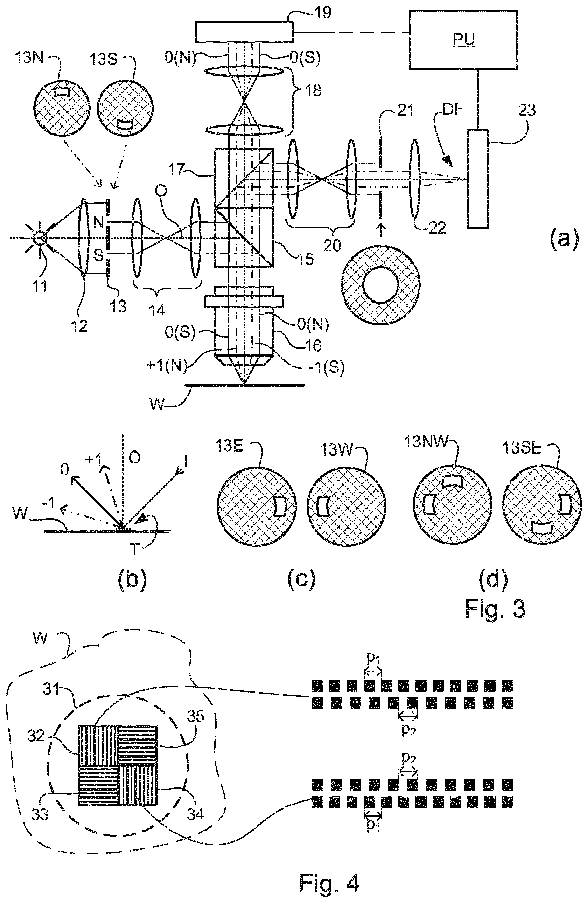

A metrology apparatus suitable for use in embodiments of the invention is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 3) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

Figure 4 is an example target on a wafer W which may be measured using a known diffraction based overlay (DBO) metrology method. Such a metrology method may be overfilled such that the full target is captured within the measurement spot 31. In this DBO metrology method, the measured asymmetry signal may be a phase difference asymmetry from a pair of complementary sub-targets (a first type sub-target or "M pad" and a second type sub-target or "W pad"). In the example target shown, there are two such pairs of sub-targets, a first pair 32, 34 oriented in a first direction of the substrate plane and a second pair 33, 35 oriented in a second direction of the substrate plane. Each sub-target comprises overlaid periodic structures or gratings in respective layers for which an overlay value is to be measured. In contrast to the more common µDBO target (where the pitches are the same per layer), a sub-target such as illustrated in Figure 4 has gratings of different pitches in each of the two layers.

More specifically a target such as illustrated in Figure 4 comprises an arrangement of two different types of sub-targets (e.g., per direction): an "M pad" or "M sub-grating" 34, 35 which comprises a bottom grating having a smaller pitch $p_1$ than that of a top grating $p_2$, and a "W pad" or "W sub-grating" 32, 33 which has these gratings reversed (i.e., it may have the same pitches as the M pad but with the larger pitch $p_2$ in the top layer, although strictly speaking the two sub-targets do not need to have the same pitches). This is shown in the cross-section detail of one of these pairs 32, 34. In this manner, the target bias changes continuously along each target. The overlay signal is encoded in the resultant imaged Moiré patterns or intensity fringes (e.g., from dark field images of diffracted radiation from the sub-targets). A phase can be measured from each image from the position of the fringes within a target region of interest. Note that the actual arrangement of these sub-targets may vary from shown.

In such a method, an asymmetry signal A may be defined as the phase difference between a diffraction order from an "M pad" and a corresponding diffraction order from a "W pad", e.g., $A = (\phi_M - \phi_W)_{+1}$ (e.g., sometimes referred to as the normal images) or $(\phi_M - \phi_W)_{-1}$ (e.g., sometimes referred to as the complementary images), where $(\phi_M - \phi_W)_{+1}$, $(\phi_M - \phi_W)_{-1}$ are the measured phase difference between the "M pad" and "W pad" of the +1 diffraction order and -1 diffraction order respectively (using other diffraction orders are possible). Optionally a sum may be taken over both diffraction orders of a complementary diffraction order pair: e.g., $A = (\phi_M - \phi_W)_{+1} + (\phi_M - \phi_W)_{-1}$. As such, it can be appreciated that the concepts described herein are applicable to different types of asymmetry signal. This measurement principle is described in Matsunobu et al, Novel diffraction-based overlay metrology utilizing phase-based overlay for improved robustness, Proc. SPIE 11611, Metrology, Inspection, and Process Control for Semiconductor Manufacturing XXXV, 1161126 (22 February 2021), which is incorporated herein by reference.

Conventionally for such targets, the overlay OV can be extracted from the phase differences between the M pad and W pad target images, e.g., Fourier plane images from a +1 diffraction order and -1 diffraction order respectively, according to the following equation:

$$OV = \frac{1}{4\pi} \frac{p_1 p_2}{p_2 + p_1} [(\phi_M - \phi_W)_{+1} + (\phi_M - \phi_W)_{-1}] \qquad (1)$$

although, as already mentioned, the phase signal in the square bracket may also be only one of $(\phi_M - \phi_W)_{+1}$ or $(\phi_M - \phi_W)_{-1}$.

As such, at least at a reasonable approximation for overlay magnitudes typically encountered, overlay OV comprises a linear relationship with the asymmetry signal A, assuming that the target is perfect and that overlay is the only asymmetry contributor for the target. In fact, targets are subject to various process variations and consequential unwanted asymmetries which are indistinguishable from overlay using conventional techniques such as just described.

WO2022008135A1, incorporated herein by reference, describes a method in the context of $\mu$DBO (where overlay is inferred from an asymmetry imbalance in complementary diffraction orders from (typically) biased targets having the same pitches in both layers) for addressing the issue of target process variation. In WO2022008135A1, it is assumed that all measurement values should be the same and any variation is due to other target asymmetries. Therefore it is assumed that the true value for the parameter of interest (e.g., overlay or aligned position) is common for all the measurement values. As such, a plurality of measurements is obtained from targets (e.g., where the number of targets number more than one) which are all located in the same vicinity or a common wafer. These concepts were based on the observation that, for a given measurement recipe or setting, the measured overlay of a target shows a significant linear dependence on a process asymmetry metric or non-overlay asymmetry metric relating to the target. A specific example of a process asymmetry metric disclosed therein was "distance to origin" DTO, a distance of an overlay regression to the origin in "asymmetry space" (more detail on this can be obtained in the aforementioned publication). As such, the method comprises finding a relationship (e.g., a proportionality constant for a linear example described below, although other functions describing more complex relationships are possible) relating the true overlay to the process asymmetry metric. As the true overlay is not known, the method is based on performing an optimization which minimizes recipe-to-recipe, target-to-target (when multiple targets are measured) and optionally polarization-to-polarization differences between measured overlay values from measurements expected to have the same true overlay (e.g., in the same vicinity on the wafer). In the same vicinity may be, for example separated by no more than 1.5mm or 1mm (e.g., having a separation distance between 10$\mu$m and 1.5mm).

As such, in an overlay example, it was proposed that all targets fulfill the relationship:

$$OV_{real} = OV_{meas\,n,P} + C_{n,P} * DTO_{n,P} \qquad (2)$$

where $OV_{real}$ is the true overlay, $OV_{meas\,N,P}$ is the measured overlay, C is a constant and DTO is the distance-to-origin as has been described (or other non-overlay asymmetry metric). N and P refer to the target and polarization, such that all parameters except the real overlay are target and measurement condition dependent (e.g., where a different measurement condition may vary in terms of one or more of wavelength, bandwidth, polarization, angle of incidence). $OV_{real}$ is assumed to be independent of the measurement conditions being optimized (e.g.. all within a particular region or distance from each other). However, there are multiple such regions on the wafer to build up the correlations defined by Equation (2). As already mentioned, a linear relationship such as described here is only one example, and the proposed methods may use other predictable relationships between overlay and a (non-overlay) asymmetry metric. Although there is only one non-overlay asymmetry metric is mentioned in Equation (2), it is appreciated that Equation (2) can be extended to include more than one non-overlay asymmetry metric.

The main assumption in WO2022008135A1, is that the variation of the real overlay $OV_{real}$ should be zero (provided that the targets are sufficiently close together); however there are multiple measured overlay values coming from different regions of the wafer. Therefore, an optimization is proposed which finds $C_{n,P}$ such that the variation of $OV_{real}$ is small (minimized). This can be realized by minimizing all individual $OV_{meas\,n,P}$ value differences on a certain location (e.g. 3 targets, for two polarizations provide 15 such differences if all differences are used).

Equation 1 may be restated into a generalized form,

$$\underline{y}_n = \underline{x}_n + \underline{c}_n \cdot \underline{z}_n \qquad (3)$$

where y is the true value for the parameter of interest, x is the measured value for the parameter of interest, c is the constant to be found and z is an asymmetry offset term which may be the DTO term in an overlay example; $n \in \{1,2,3, ..., N\}$ and $N$ is the total number of measurement conditions (e.g. target/polarization combinations). For example, $N$ may be 6 for an example of two polarizations and three different marks or mark types.

WO2022008135A1 also disclosed a specific alignment embodiment, based on the same basic assumption that there is only one true alignment position $AL_{real}$ for all measurement values of one or multiple targets (alignment marks) within the same vicinity. There are also asymmetry metrics $Asym_{n,P}$ for alignment which may be used in place of DTO determinations. Such asymmetry metrics may comprise, for example a color-to-color asymmetry metric, an intensity difference metric (difference of two complementary diffraction orders), a (bottom grating) asymmetry measurement performed using another apparatus such as a scatterometer as may be used for overlay measurement, a mark deformation estimate from an external algorithm (e.g., Kramers Kronig type inference schemes), or a derived estimand such as derivative of diffraction order intensity difference or ratio w.r.t wavelength. In such an example, Equation (2) becomes:

$$AL_{real} = AL_{meas\ n,P} + C_{n,P} * Asym_{n,P} \qquad (4)$$

where $AL_{meas\ n,P}$ are the measured alignment values.

An improvement on the teachings of WO2022008135A1 will be described, mainly in the context of DBO metrology using targets such as illustrated in Figure 4, although some aspects (in particular the calibration aspect) is more generally applicable to other metrology techniques including μDBO). The proposed method, according to an embodiment, has an advantage of not requiring measurements of each target with different measurement conditions (e.g., wavelengths and/or polarizations), although of course measurement data relating to different measurement conditions may still be used. This advantage is obtained due to calibration based on trusted reference data. However such external reference data is not a strict requirement and other embodiments may use reference data of the same type as the phase calibration data (e.g., relating to different measurement conditions such as different wavelengths and/or polarizations).

The concept comprises obtaining metrology data relating to one or more Figure 4 type targets or other targets from which a phase metric can be measured, e.g. from imaged intensity fringes of diffracted radiation from a target for measuring a parameter of interest such as overlay (position of a second layer with respect to a first layer, note that the terms first layer and second layer do not preclude the possible presence of intervening layers) or position. The method may comprise determining both an intensity asymmetry metric value for each of one or more intensity asymmetry metrics, and a phase difference metric value, from this metrology data.

The phase difference metric may be obtained from a difference in position of such fringes in different sub-target types of a pair (e.g., M-pad and W-pad), and may comprise a raw parameter of interest value (e.g., a raw overlay value, for example as determined according to Equation (1)). Each of the intensity asymmetry metrics may relate to an imbalance or asymmetry in one or more intensity metrics between diffraction orders of a pair of complementary diffraction orders (e.g., +1 and -1 orders) from a sub-target or each sub-target, where each intensity metric relates to an intensity or amplitude of the fringes.

A corrected parameter of interest value may be obtained from the phase difference metric (e.g., measured overlay such as determined according to Equation (1)) and the intensity asymmetry metric values, using predetermined or pre-calibrated asymmetry coefficients, the pre-calibrated asymmetry coefficients comprising a respective pre-calibrated asymmetry coefficient for each intensity asymmetry metric (where each intensity asymmetry metric may be derived from a respective different intensity metric). For example, the corrected parameter of interest value may comprise a linear sum of the phase difference metric and the product of each intensity asymmetry metric value with its respective asymmetry coefficient.

The asymmetry coefficients may be calibrated in a calibration phase. In a the context of using targets such as illustrated in Figure 4 (or alignment context), the calibration phase may comprise obtaining calibration data comprising both phase calibration data relating to the phase difference metric, e.g., uncorrected or raw phase calibration data such as uncorrected parameter of interest data (e.g., obtained according to Equation (1)) and intensity calibration data (relating to the intensity asymmetry metrics) from each of a plurality of such targets (or alignment marks). However, such a calibration method is also applicable to other metrology techniques such as μDBO, and in such a context, the calibration data may comprise uncorrected parameter of interest or overlay data determined according to conventional μDBO techniques and additional intensity asymmetry metric data.

Returning to the Figure 4 target context, different intensity asymmetry metrics may be determined from different intensity metrics and combinations thereof, which describe an imbalance in diffraction order (e.g., fringe) intensity between diffraction orders of a complementary pair of diffraction orders from each target and/or each sub-target thereof. Also reference data may be obtained, e.g., trusted parameter of interest reference data. The reference data may be obtained from the same targets as measured to obtain the calibration data or reference targets/structures in the same vicinity as the targets measured to obtain the calibration data. The "same vicinity" may describe, for example being separated by no more than 1.5mm or 1mm (e.g., having a separation distance between 10$\mu$m and 1.5mm).

The calibration phase may find the asymmetry coefficients (for each intensity asymmetry metric) which minimize the difference between the phase calibration data and reference data when summed with the asymmetry coefficient weighted intensity calibration data.

Optionally, the calibration phase may additionally train one or more model term coefficients, wherein each corresponding model term describes a known spatial pattern or fingerprint over a wafer or a portion thereof (e.g., a field). The model term may be described by a function dependent only on wafer or field location, i.e., and not having any dependence on the metrology data. Such a function may be any suitable mathematical function describing a shape over two dimensions, e.g., a polynomial, Fourier or Zernike function for example, and may describe known shapes encountered in metrology. More specifically, these model terms may be used to model any "metrology-to-device" offset. e.g., any error resulting from the difference in measurement method, tool and/or target used in obtaining the calibration data/metrology data and the measurement method, tool and/or target used in obtaining the reference data (e.g., where the metrology data relates to a plurality of wafers).

Optionally, a filter may be applied to asymmetry metric data, (uncorrected) phase metric data and/or reference data e.g., either during the calibration as part of the merit function/optimization function or as a data processing step prior to optimization. The filter may comprise, for example, a smoothing filter favoring smooth solutions, and/or a merit function filter for varying the merit function being optimized. For example, the merit function filter may define a particular weighting on the optimization (e.g., per location/region weighting), thereby making the learning adaptable.

Optionally, the learning may be such that the asymmetry coefficients are location-dependent (e.g., at a per-location scale or other region scale such as edge locations vs center locations). This may be achieved by defining a suitable model matrix for combination with the asymmetry metric data, so as to optimize for the location-dependent asymmetry coefficients. Alternatively or in addition to location-dependency, asymmetry coefficients with other dependencies may be defined, such as context dependency. Examples of context dependency may include, for example, asymmetry coefficients which may be defined with chuck dependency (e.g., the lithography chuck used during exposure of either grating of the target), etch-chamber dependency (e.g., the etch chamber/tool used to etch either grating of the target) and/or CMP tool dependency (e.g., the CMP tool used in polishing).

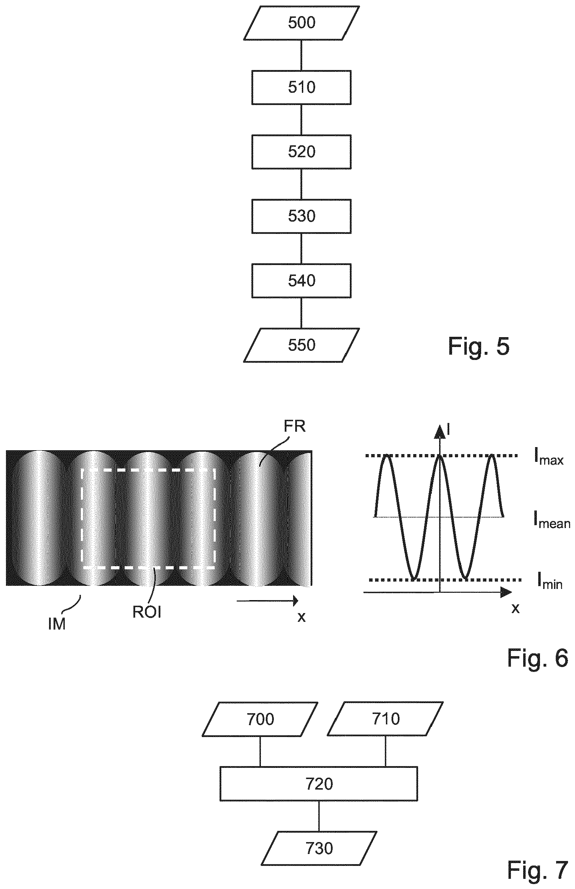

Figure 5 is a flowchart describing such a calibration method according to an embodiment. At step 500, calibration metrology data may be obtained from one or more calibration wafers, each comprising a number of metrology targets (e.g., a $\mu$DBO, Figure 4 target or alignment target/mark). The calibration metrology data in the specific example to be described may be DBO metrology data relating to Figure 4 type targets, comprising calibration phase difference metric data and/or parameter of interest data and calibration intensity metric data. The calibration phase difference metric data and calibration intensity metric data may be obtained from (e.g., dark-field) images of individual diffraction orders of radiation diffracted from such targets (with regions of interest defined for individual sub-targets). Each of the images of a sub-target comprises moiré fringes due to the different pitches in the (sub-) target. The phase difference metric can be obtained by the position of these fringes for M and W sub-target pairs, while the intensity metric may relate to fringe intensity in these images.

The calibration phase difference metric data and/or parameter of interest data may describe or relate to a phase difference between diffracted radiation from the M-pad and W-pad (e.g., for one corresponding diffraction order per pad or averaged over more than one corresponding diffraction order) of a plurality of targets from one or more calibration wafers or a uncorrected parameter of interest data (e.g., uncorrected overlay or position data) determined therefrom, e.g., this may be as conventionally determined in known DBO (or alignment) methods from the positions of the imaged fringes. In a specific embodiment, this calibration phase difference metric data and/or parameter of interest data may be raw or uncorrected overlay data determined, e.g., according to Equation (1).

Figure 6 illustrates an image IM which may be obtained from imaging of a single diffraction order having diffracted from a sub-target of a Figure 4 type target. The image comprises multiple Moiré fringes FR providing a periodic or sinusoidal intensity signal corresponding the sub-target's direction of periodicity. A corresponding plot of intensity I against image position (in the x-direction as shown) within a region of interest ROI is also shown (images are typically processed to only use image portions within a region of interest, e.g., a central region, of each sub-target to mitigate for target edge-effects and the effects of surrounding structure for example). Labeled on this plot is maximum intensity $I_{max}$, mean intensity $I_{mean}$ and minimum intensity $I_{min}$, which are values which may be used as, or to determine, various intensity metrics and intensity asymmetry metrics described herein.

Some specific examples of intensity metrics will now be described, which act as proxies for the diffraction intensity or amplitude signal. The calibration intensity asymmetry metric data may comprise any one or more of these metrics. The intensity metric may be a function of one or more of a fringe intensity maximum, a fringe intensity minimum or a fringe intensity average or mean (although any other measure of fringe intensity is possible), which is determined per diffraction order of a complementary pair. For example the intensity metric $\alpha_{\pm}$ may comprise any of the metrics $\alpha_1$ ... $\alpha_8$, where $\alpha_+$ is the intensity metric for a first diffraction order of the complementary pair (e.g., the +1 order) and $\alpha_-$ is the intensity metric for a second diffraction order of the complementary pair (e.g., the -1 order):

$$\alpha_1 = \frac{1}{2}(I_{max} + I_{min})$$

$$\alpha_2 = \frac{1}{2}\left(\sqrt{I_{max}} + \sqrt{I_{min}}\right)$$

$$\alpha_3 = \frac{I_{max} + I_{min}}{I_{max}}$$

$$\alpha_4 = \frac{\sqrt{I_{max}} + \sqrt{I_{min}}}{\sqrt{I_{max}}}$$

$$\alpha_5 = \frac{1}{2}(I_{max} - I_{min})$$

$$\alpha_6 = \frac{1}{2}\left(\sqrt{I_{max}} - \sqrt{I_{min}}\right)$$

$$\alpha_7 = \frac{I_{max} - I_{min}}{I_{max}}$$

$$\alpha_8 = \frac{\sqrt{I_{max}} - \sqrt{I_{min}}}{\sqrt{I_{max}}}$$

as such, the intensity metrics may describe, *inter alia,* a mean intensity, an amplitude intensity and/or a diffraction efficiency of the minor and/or major grating, and may optionally be normalized.

At step 510, calibration intensity asymmetry metric data *a* may be determined from the calibration intensity metric data $\alpha_{\pm}$. The calibration intensity asymmetry metric data may describe an intensity or amplitude imbalance between complementary pairs of the same diffraction orders. As such, the intensity imbalance metric may comprise a measure of imbalance the intensity metric between the +1 and -1 orders, for each of the intensity metrics, i.e., generally $a_k = f(\alpha_{k+}, \alpha_{k-})$ where k may be any of 1 to 8 above (or any other suitable metric). By way of example, a first intensity asymmetry metric $a_1$ dataset may be determined from $\alpha_{1+}$, $\alpha_{1-}$ and another intensity asymmetry metric $a_4$ dataset may be determined from $\alpha_{4+}$, $\alpha_{4-}$. This can be done for any or all of the aforementioned intensity metrics (or others); e.g., any subset or all of intensity metrics $\alpha_1 \dots \alpha_8$ determined for the calibration metrology data.

The calibration intensity asymmetry metric data may comprise or be based on, for example, a difference or ratio of the intensity asymmetry metric for the +1 or -1 diffraction orders. Specific examples may comprise, *inter alia:*

$$a_k = \alpha_{k+} - \alpha_{k-}$$

$$a_k = \frac{\alpha_{k+} - \alpha_{k-}}{\alpha_{k+} + \alpha_{k-}}$$

$$a_k = \frac{\alpha_{k+}}{\alpha_{k-}}$$

$$a_k = \log\left(\frac{\alpha_{k+}}{\alpha_{k-}}\right)$$

At step 520, a post processing step may be applied. This step is optional and may be used, in particular, when the calibration uses a linear merit function to determine a linear correction. This is because non-linearity may occur if the target deformation becomes large. Such a step may comprise determining one or more additional (e.g., power) terms $a_{new}$ in a Taylor-like expansion, where $a_{new}$ may be one or more of (and assuming $a_x^1$ is already determined):

$$a_{new} = a_x^{\frac{1}{2}}$$

$$a_{new} = a_x^2$$

$$a_{new} = a_x^3$$

$$a_{new} = a_x^4$$

etc.

At step 530, reference data may be obtained, e.g., comprising trusted or known values for the parameter of interest for the calibration wafer(s). Such reference data may be measured, for example, using known scatterometry techniques (e.g., with corrections for process variation asymmetries) and/or from scanning electron microscope/e-beam metrology.

At step 540, an optimization problem may be found to minimize the difference between the calibration phase difference metric data (e.g., raw/uncorrected overlay data $OV_{raw}$) and the (trusted) reference data $OV_{ref}$. In an embodiment, there may be at least four intensity asymmetry metrics and therefore four coefficients $c_1$, $c_2$, $c_3$, $c_4$ to be calibrated. This may be preferable from a performance point of view as (per direction) a target may comprise two sub-targets each comprising two gratings. However, models based on fewer (at least one) or more intensity asymmetry metrics can be used within the scope of the disclosure, as even with one or two intensity asymmetry metrics, the correction can be expected to improve performance with respect to the raw parameter of interest data.

In an embodiment, the model or merit function to be optimized may be a linear function, for example:

$$OV_{ref} = OV_{raw} + c_1 a_1 + c_2 a_2 + c_3 a_3 + c_4 a_4$$

or more generally:

$$OV_{ref} = OV_{raw} + \cdots + c_k a_k$$

or in terms of matrices (for 1 calibration wafer $\mathbf{A}_{waf1}$) for a four intensity metric example:

$$OV_{ref} = OV_{raw} + \mathbf{A}_{waf1}\mathbf{c}$$

$$\mathbf{OV_{cor}} = \begin{bmatrix} ov(x_1,y_1) \\ ov(x_2,y_2) \\ ov(x_3,y_3) \\ \vdots \\ ov(x_{i-1},y_{i-1}) \\ ov(x_i,y_i) \end{bmatrix} + \begin{bmatrix} a_1(x_1,y_1) & a_2(x_1,y_1) & a_3(x_1,y_1) & a_4(x_1,y_1) \\ a_1(x_2,y_2) & a_2(x_2,y_2) & a_3(x_2,y_2) & a_4(x_2,y_2) \\ a_1(x_3,y_3) & \cdots & \ddots & \vdots \\ \vdots & \vdots & \ddots & \vdots \\ a_1(x_{i-1},y_{i-1}) & a_2(x_{i-1},y_{i-1}) & a_3(x_{i-1},y_{i-1}) & a_4(x_{i-1},y_{i-1}) \\ a_1(x_i,y_i) & a_2(x_i,y_i) & a_3(x_i,y_i) & a_4(x_i,y_i) \end{bmatrix} \begin{bmatrix} c_1 \\ c_2 \\ c_3 \\ c_4 \end{bmatrix}$$

where there are i locations per wafer (the *x* and *y* referring to the orientation of the sub-targets). It can be appreciated, however, other more complex (non-linear) models may also be used. Coefficients $c_1$ - $c_k$ can be determined which minimize the difference between the reference data or trusted parameter of interest data $OV_{ref}$ and the calibration phase difference metric data (e.g., raw/uncorrected overlay data $OV_{raw}$).

Where there is more than one calibration wafer (e.g., *l* wafers, *waf*1 - *wafl),* then the merit function may be, for example:

$$OV_{\mathrm{ref}} = OV_{\mathrm{raw}} + Ac = \begin{bmatrix} OV_{raw1} \\ OV_{raw2} \\ \vdots \\ OV_{rawl} \end{bmatrix} + \begin{bmatrix} A_{waf1} \\ A_{waf2} \\ \vdots \\ A_{wafl} \end{bmatrix} \begin{bmatrix} c_1 \\ c_2 \\ c_3 \\ c_4 \end{bmatrix}$$

It can be appreciated, however, that the sampling locations (e.g., position and/or their number) for the different wafers may differ. The skilled person will recognize how to adapt the merit function accordingly.

In embodiments where step 520 is performed, the single wafer asymmetry metric matrices $A_{waf1}$, ... , $A_{wafl}$ may each comprise additional columns for each of the additional asymmetry terms (e.g., an additional column for some or all of: $a_1^2, a_2^2, a_3^2, a_4^2$ and/or for other powers).

The optimization at step 540 may use any standard optimization technique such as a least-squares optimization for example. Alternatively or in addition, the optimization may optionally be regularized, e.g., an L1 regularized least squares optimization or L2 regularized least squares optimization.

In an embodiment the merit function may comprise a wafer model matrix $M_{MTD}$ which comprises one or more additional model terms, so as to train respective model term coefficients $c_{MTd,1}$ - $c_{MTD,n}$ (e.g., comprised within matrix c), wherein each model term describes a known spatial pattern or fingerprint over a wafer or a portion thereof (e.g., a field). This may enable the optimization to co-optimize for a static error fingerprint or metrology-to-device (MTD) fingerprint (e.g., which may be the same for all wafers and not a function of the measured data/observations, only its spatial location). Wafer model-term index *n* describes the number of (e.g., orthogonal) modes for modeling this MTD static error (for example *n* may lie in the range of 6 to 50).

In such an embodiment, the merit function may take the form (for example):

$$OV_{\mathrm{ref}} = \begin{bmatrix} OV_{raw1} \\ OV_{raw2} \\ \vdots \\ OV_{rawl} \end{bmatrix} + \begin{bmatrix} A_{waf1}M_{\mathbf{MTD}} \\ A_{waf2}M_{\mathbf{MTD}} \\ \vdots \\ A_{wafl}M_{\mathbf{MTD}} \end{bmatrix} \begin{bmatrix} c_1 \\ c_2 \\ c_3 \\ c_4 \\ c_{\mathrm{MTD,1}} \\ c_{\mathrm{MTD,2}} \\ \vdots \\ c_{\mathrm{MTD,n}} \end{bmatrix}$$

This concept of a wafer model matrix may be extended to defining model matrices for different contexts, e.g., different groups of wafers grouped according to the chuck used for exposure, CMP tool used and/or etch chamber used. As such, a respective model matrix may be applied per group of wafers. Other known MTD processing techniques for modeling MTD fingerprints may be used.

Preferably, the total sum of (interpolated) locations on all calibration wafers should be (e.g., much) greater than wafer model-term index *n*. Additionally, calibration data from a plurality of calibration wafers are preferable in such an embodiment to better condition the matrix; multiple wafers aids capture of the 'mean' (static) error fingerprint by the model term coefficients and reconstruction of the dynamic error fingerprint by the intensity asymmetry metrics.

Any suitable function can generate the model terms comprised within wafer model matrix $M_{MTD}$. Any number of model terms may be comprised within wafer model matrix $M_{MTD}$, e.g., each describing a particular known or expected shape, the respective coefficients will simply go to zero for shapes that are not present.

As an alternative to applying a wafer model matrix to the actual optimization, the same (or similar) result may be achieved by applying the model terms as a pre-processing step to the calibration metrology data prior to optimization.

One or more filter terms may be added to the merit function of the optimization of step 540, e.g., once all locations per wafer have been measured. The filter term(s) may be included in addition to one or more wafer model terms (additional to wafer model matrix $M_{MTD}$) or by itself, without the wafer model terms. One such filter term may be used to preprocess asymmetries, e.g., by applying a spatial smoothing filter which smooths the intensity asymmetry metric data (e.g., an outlier removal filter). As such, a smoothing filter may provide noise reduction by spatial averaging. Of course, such a smoothing filter may also be applied to preprocess the phase difference metric data (e.g., raw/unprocessed parameter of interest/overlay data).

Alternatively or in addition, a merit filter term may be provided which changes the merit function, e.g., to make the learning adaptable. Such a merit filter term may apply a weighting on the optimization (e.g., per location/region weighting). By way of a specific example, such a merit filter may enable selection of a particular aspect of the MTD error which is to be minimized (e.g., at wafer edge only, intrafield only, interfield only or non-binary weighting between such schemes for example). In another example, if the sampling scheme used to obtain the calibration metrology data and reference data is different, the merit filter term may enable selection between the two sampling schemes. In another example, such a filter may implement a "dies in spec" merit function which aims to maximize the number of dies that are within specification, rather than applying an averaged optimization across the substrate (e.g., a least-squares optimization). As such, a "dies-in-spec" optimization uses prior knowledge of the product (the die layout) when optimizing the process parameter. A least squares optimization typically treats each location equally, without taking into account the die layout. As such, a least squares optimization may prefer a correction which "only" results in four locations being out-of-specification, but each in a different die, over a correction which has seven locations out-of-specification, but which only affect two dies (e.g., four defects in one die, three in another). However, it will be apparent that the later scenario is preferable from a yield perspective.

These are only examples of the filters which may be applied, any suitable filter may be applied in principle.

In such an embodiment, the merit function may take the form (for example):

$$\mathbf{OV}_{\mathrm{ref}} = \begin{bmatrix} \mathbf{OV}_{raw1} \\ \mathbf{OV}_{raw2} \\ \vdots \\ \mathbf{OV}_{rawl} \end{bmatrix} + \begin{bmatrix} \mathbf{F}_a\mathbf{A}_{waf1}\mathbf{M}_{\mathbf{MTD}} \\ \mathbf{F}_a\mathbf{A}_{waf2}\mathbf{M}_{\mathbf{MTD}} \\ \vdots \\ \mathbf{F}_a\mathbf{A}_{wafl}\mathbf{M}_{\mathbf{MTD}} \end{bmatrix} \begin{bmatrix} c_1 \\ c_2 \\ c_3 \\ c_4 \\ c_{\mathrm{MTD},1} \\ c_{\mathrm{MTD},2} \\ \vdots \\ c_{\mathrm{MTD,n}} \end{bmatrix}$$

As already stated the filter matrix $\mathbf{F}_a$ may be implemented independently of wafer model matrix $\mathbf{M_{MTD}}$. The filter matrix $\mathbf{F}_a$, in an embodiment, may comprise the product of merit matrix $\mathbf{M}_m$ and pseudo-inversed smoothing matrix $\mathbf{M}_s^{\dagger}$; i.e.,

$$\mathbf{F}_a = \mathbf{M}_m\mathbf{M}_s^{\dagger}.$$

In an embodiment, an additional model matrix may be applied which can be used to train location-dependent or region-dependent coefficients (i.e., the matrix c may be extended to include position dependent coefficients). Such an embodiment may be employed when there are different asymmetry modes which can be separated spatially. Naturally such an embodiment increases the complexity of the model as there is now k × u coefficients to train instead of k (k=4 in the specific examples given in this section), where u is the number of modes (locations/regions to be treated separately).

Finally, the output 550 of the method are calibrated coefficient matrix c (e.g., calibrated coefficients $c_1$ to $c_4$ in the specific examples given), and optionally calibrated model term coefficients $c_{MTD,1}$ to $c_{MTD,n}$ where applicable.

Figure 7 is a flowchart of a method of performing a measurement using the concepts disclosed herein. Metrology data 700 is obtained comprising phase difference metric data $OV_{raw}$ (e.g. parameter of interest or overlay measurement data as measured from one or more DBO targets according to Equation (1)) and intensity asymmetry metric data (relating to one or more intensity asymmetry metrics determined from fringe intensity using the methods which have been already described). Also obtained are one or more pre-calibrated coefficients 710 (corresponding to the number of intensity asymmetry metrics described within the intensity asymmetry metric data), e.g., as obtained using the method of Figure 5. The pre-calibrated coefficients 710 may be applied 720 to the intensity asymmetry metric data so as to correct the phase difference metric data $OV_{raw}$, thereby determining corrected phase difference metric data $OV_{cor}$ 730 (e.g., corrected parameter of interest or overlay data); e.g., according to (using a four intensity asymmetry metric example):

$$OV_{\mathrm{cor}} = OV_{\mathrm{raw}} + c_1a_1 + c_2a_2 + c_3a_3 + c_4a_4$$

Optionally, at step 720, the equation for the corrected phase difference metric data $OV_{cor}$ may also include model terms $\mathbf{M_{MTD}}$ weighted by their corresponding model term coefficients $c_{MTD,1}$ to $c_{MTO,n}$, i.e., $\mathbf{M_{MTD}}c_{MTD}$. This may compensate for the static MTD error. This may also be done outside of the metrology tool, and inside the control feedback loop.

While the targets described above are metrology targets specifically designed and formed for the purposes of measurement, in other embodiments, properties may be measured on targets which are functional parts of devices formed on the substrate. Many devices have regular, grating-like structures. The terms 'target grating' and 'target' as used herein do not require that the structure has been provided specifically for the measurement being performed. Further, pitch P of the metrology targets is close to the resolution limit of the optical system of the scatterometer, but may be much larger than the dimension of typical product features made by lithographic process in the target portions C. In practice the lines and/or spaces of the overlay gratings within the targets may be made to include smaller structures similar in dimension to the product features.

In association with the physical grating structures of the targets as realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the methods disclosed herein.

While the embodiments disclosed above are described in terms of diffraction based overlay measurements (e.g., measurements made using the second measurement branch of the apparatus shown in Figure 3(a)), in principle the same models can be used for pupil based overlay measurements (e.g., measurements made using the first measurement branch of the apparatus shown in Figure 3(a)). Consequently, it should be appreciated that the concepts described herein are equally applicable to diffraction based overlay measurements and pupil based overlay measurements.

Further embodiments according to the present invention are described in below numbered clauses:

1. A method of metrology, comprising:

obtaining metrology data relating to one or more targets on a substrate, the metrology data comprising intensity metric data relating to one or more intensity metrics, and phase difference metric data relating to a phase difference metric;
determining intensity asymmetry metric data from said intensity metric data, said intensity asymmetry metric data describing, for each said intensity metric, an asymmetry in said intensity metric data between diffraction orders of a complementary pair of diffraction orders following diffraction by said one or more targets;
obtaining one or more pre-calibrated asymmetry coefficients; and
determining a value for a parameter of interest from said phase difference metric data, and said intensity asymmetry metric data as weighted by said pre-calibrated asymmetry coefficients.

2. A method according to clause 1, wherein said one or more intensity metrics comprise a plurality of intensity metrics, each intensity metric having at least one associated asymmetry coefficient.
3. A method according to clause 2, wherein said plurality of intensity metrics comprise at least four intensity metrics.
4. A method according to any preceding clause, wherein each said intensity metric comprises a function of one or more of a fringe intensity maximum, a fringe intensity minimum or a fringe intensity mean of fringes imaged from each said diffraction order.
5. A method according to clause 4, wherein said phase difference metric data relates to a difference in position of said fringes imaged from one or each said diffraction order, from a first sub-target type and a second sub-target type of each said at least one target.
6. A method according to any preceding clause, wherein each said intensity asymmetry metric relates to a difference or ratio based metric respectively for each said intensity metric, of intensity metric data values for a first one of said complementary pair of diffraction orders and a second one of said complementary pair of diffraction orders.
7. A method according to any preceding clause, further comprising obtaining one or more pre-calibrated model term coefficients and one or more associated model terms, each model term describing a function of substrate location which is independent of the parameter of interest; and
wherein said step of determining a value for a parameter of interest further determines the value for the parameter of interest based on one or more associated model terms weighted by said pre-calibrated model term coefficients.
8. A method according to any preceding clause, wherein said intensity asymmetry metric data comprises one or more additional powers of one or more of said intensity asymmetry metrics.
9. A method according to any preceding clause, wherein said step of determining a value for a parameter of interest comprises determining a linear sum of said phase difference metric data and said intensity asymmetry metric data as weighted by said pre-calibrated asymmetry coefficients.

10. A method according to any preceding clause, wherein said parameter of interest is overlay.

11. A method according to any preceding clause, wherein said phase difference metric data comprises uncorrected overlay data.

12. A method according to any preceding clause, wherein said one or more targets each comprise at least one pair of sub-targets, wherein a first sub-target of the at least one pair comprises a first layer periodic structure having a first pitch and a second layer periodic structure having a second pitch, and a second sub-target of the at least one pair comprises a first layer periodic structure having the second pitch and a second layer periodic structure having the first pitch.

13. A method according to clause 12, wherein said one or more targets each comprise two of said pairs of sub-targets, each said pair oriented in different, mutually orthogonal, directions.

14. A method according to any preceding clause, comprising an initial calibration step for calibrating said asymmetry coefficients, the initial calibration step comprising:

obtaining calibration metrology data relating to a plurality of targets on at least one calibration substrate, the calibration metrology data comprising intensity metric data relating to said intensity metrics, and said phase difference metric data;

determining calibration intensity asymmetry metric data from said intensity metric data, said calibration intensity asymmetry metric data describing, for each said intensity metric, an asymmetry in said intensity metric data between diffraction orders of a complementary pair of diffraction orders following diffraction by said targets;

obtaining reference data relating to said parameter of interest; and

optimizing said one or more asymmetry coefficients so as to minimize a difference between said reference data and said uncorrected parameter of interest data when corrected with a combination of said calibration intensity asymmetry metric data and said asymmetry coefficients.

15. A method according to clause 14, wherein said optimizing step comprises minimizing a merit function relating said reference data to said uncorrected parameter of interest data and said calibration intensity asymmetry metric data as weighted by said asymmetry coefficients.

16. A method according to clause 15, wherein said merit function includes individual terms for respective weighted subsets of said calibration intensity asymmetry metric data, each said weighted subset relating to a respective one of said intensity metrics and weighted by a respective one of said plurality of asymmetry coefficients.

17. A method according to clause 16, wherein said merit function comprises a linear summation of said weighted subsets with said uncorrected parameter of interest data.

18. A method according to any of clauses 14 to 17, further comprising calibrating one or more model term coefficients, each model term coefficient corresponding to a respective model term describing a function of substrate location which is independent of the parameter of interest.

19. A method according to clause 18, wherein said optimization step comprises optimizing simultaneously for the asymmetry coefficients and model term coefficients.

20. A method according to clause 18 or 19, wherein said optimization step comprises applying the one or more model terms to the calibration intensity asymmetry metric data as part of the optimization.

21. A method according to clause 18 or 19, comprising applying the one or more model terms to the calibration intensity asymmetry metric data as part of a pre-processing step.

22. A method according to any of clauses 14 to 21, comprising applying at least one filter term to the calibration intensity asymmetry metric data prior to or as part of the optimization step.

23. A method according to clause 22, wherein said at least one filter term comprises a smoothing filter term.

24. A method according to clause 22 or 23, wherein said at least one filter term comprises a merit filter term enabling configuration of an aspect of the optimization in said optimization step.

25. A method according to any preceding clause, wherein said one or more pre-calibrated asymmetry coefficients comprise location or region dependent pre-calibrated asymmetry coefficients and/or context dependent pre-calibrated asymmetry coefficients.

26. A method according to any preceding clause, comprising:
determining a process correction based on said value for a parameter of interest.

27. A method according to clause 26, comprising performing a subsequent exposure action based on the process correction.

28. A method of calibrating a plurality of asymmetry coefficients, each said asymmetry coefficient relating to a respective intensity metric, the method comprising:

obtaining calibration metrology data relating to a plurality of targets on at least one calibration substrate, the calibration metrology data comprising intensity metric data relating to said intensity metrics, and uncorrected parameter of interest data;

determining calibration intensity asymmetry metric data from said intensity metric data, said calibration intensity asymmetry metric data describing, for each said intensity metric, an asymmetry in said intensity metric data between diffraction orders of a complementary pair of diffraction orders following diffraction by said targets;

obtaining reference data relating to said parameter of interest; and

optimizing said asymmetry coefficients so as to minimize a difference between said reference data and said uncorrected parameter of interest data when corrected with a combination of said calibration intensity asymmetry metric data and said asymmetry coefficients.

29. A method according to clause 28, wherein said plurality of intensity metrics comprise at least four intensity metrics.

30. A method according to clause 28 or 29, wherein each said intensity metric comprises a function of one or more of a fringe intensity maximum, a fringe intensity minimum or a fringe intensity mean of fringes imaged from each said diffraction order.

31. A method according to any of clauses 28 to 30, wherein each said intensity asymmetry metric relates to a difference or ratio based metric respectively for each said intensity metric, of intensity metric data values for a first one of said complementary pair of diffraction orders and a second one of said complementary pair of diffraction orders.

32. A method according to any of clauses 28 to 31, wherein said parameter of interest is overlay.

33. A method according to any of clauses 28 to 31, wherein said parameter of interest is aligned position.

34. A method according to any of clauses 28 to 33, wherein said optimizing step comprises minimizing a merit function relating said reference data to said uncorrected parameter of interest data and said calibration intensity asymmetry metric data as weighted by said asymmetry coefficients.

35. A method according to clause 34, wherein said merit function includes individual terms for respective weighted subsets of said calibration intensity asymmetry metric data, each said weighted subset relating to a respective one of said intensity metrics and weighted by a respective one of said plurality of asymmetry coefficients.

36. A method according to clause 35, wherein said merit function is a linear summation of said weighted subsets with said uncorrected parameter of interest data.

37. A method according to clause 34, 35 or 36, wherein said merit function includes one or more additional terms, each relating to a power other than one of one or more of said subsets of said calibration intensity asymmetry metric data.

38. A method according to any of clauses 28 to 37, further comprising calibrating one or more model term coefficients, each model term coefficient corresponding to a respective model term describing a function of substrate location which is independent of the parameter of interest.

39. A method according to clause 38, wherein said optimization step comprises optimizing simultaneously for the asymmetry coefficients and model term coefficients.

40. A method according to clause 38 or 39, wherein said optimization step comprises applying the one or more model terms to the calibration intensity asymmetry metric data as part of the optimization.

41. A method according to clause 38 or 39, comprising applying the one or more model terms to the calibration intensity asymmetry metric data as part of a pre-processing step.

42. A method according to any of clauses 28 to 41, comprising applying at least one filter term to the calibration intensity asymmetry metric data prior to or as part of the optimization step.

43. A method according to clause 42, wherein said at least one filter term comprises a smoothing filter term.

44. A method according to clause 42 or 43, wherein said at least one filter term comprises a merit filter term enabling configuration of an aspect of the optimization in said optimization step.

45. A method according to any of clauses 28 to 44, wherein said one or more targets each comprise at least one pair of sub-targets, wherein a first sub-target of the at least one pair comprises a first layer periodic structure having a first pitch and a second layer periodic structure having a second pitch, and a second sub-target of the at least one pair comprises a first layer periodic structure having the second pitch and a second layer periodic structure having the first pitch.

46. A method according to any of clauses 28 to 44, wherein said one or more targets each comprise at least one pair of sub-targets, wherein each sub-target of the pair comprises a first layer periodic structure and a second layer periodic structure each having a first pitch, wherein a first sub-target of the at least one pair comprises a first bias offset between the first layer periodic structure and the second layer periodic structure and a second sub-target of the at least one pair comprises a second bias offset between the first layer periodic structure and the second layer periodic structure.

47. A method according to clause 45 or 46, wherein said one or more targets each comprise two of said pairs of sub-targets, each said pair oriented in different, mutually orthogonal, directions.

48. A method according to any of clauses 28 to 47, wherein said asymmetry coefficients comprise location or region dependent asymmetry coefficients and/or context dependent pre-calibrated asymmetry coefficients.

49. A computer program comprising program instructions operable to perform the method of any preceding clause, when run on a suitable apparatus.

50. A non-transient computer program carrier comprising the computer program of clause 49.

51. A processing arrangement comprising: a non-transient computer program carrier comprising a computer program comprising program instructions operable to perform the method of any preceding clause, when run on a suitable apparatus; and a processor operable to run the computer program comprised on said non-transient computer program carrier.

52. A lithographic apparatus comprising: an alignment sensor; a patterning device support for supporting a patterning device; a substrate support for supporting a substrate; and the processing arrangement of clause 51.

53. A metrology apparatus comprising: a support for a substrate; an optical system for illuminating said structure with measurement radiation; a detector for detecting the measurement radiation scattered by the structure; and the processing arrangement of clause 51.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1.  A method of metrology, comprising:

    obtaining metrology data relating to one or more targets on a substrate, the metrology data comprising intensity metric data relating to one or more intensity metrics, and phase difference metric data relating to a phase difference metric;
    determining intensity asymmetry metric data from said intensity metric data, said intensity asymmetry metric data describing, for each said intensity metric, an asymmetry in said intensity metric data between diffraction orders of a complementary pair of diffraction orders following diffraction by said one or more targets;
    obtaining one or more pre-calibrated asymmetry coefficients; and
    determining a value for a parameter of interest from said phase difference metric data, and said intensity asymmetry metric data as weighted by said pre-calibrated asymmetry coefficients.

2.  A method as claimed in claim 1, wherein said one or more intensity metrics comprise a plurality of intensity metrics, each intensity metric having at least one associated asymmetry coefficient.

3.  A method as claimed in any preceding claim, wherein each said intensity metric comprises a function of one or more of a fringe intensity maximum, a fringe intensity minimum or a fringe intensity mean of fringes imaged from each said diffraction order.

4. A method as claimed in claim 3, wherein said phase difference metric data relates to a difference in position of said fringes imaged from one or each said diffraction order, from a first sub-target type and a second sub-target type of each said at least one target.

5. A method as claimed in any preceding claim, wherein each said intensity asymmetry metric relates to a difference or ratio based metric respectively for each said intensity metric, of intensity metric data values for a first one of said complementary pair of diffraction orders and a second one of said complementary pair of diffraction orders.

6. A method as claimed in any preceding claim, further comprising obtaining one or more pre-calibrated model term coefficients and one or more associated model terms, each model term describing a function of substrate location which is independent of the parameter of interest; and
wherein said step of determining a value for a parameter of interest further determines the value for the parameter of interest based on one or more associated model terms weighted by said pre-calibrated model term coefficients.

7. A method as claimed in any preceding claim, wherein said intensity asymmetry metric data comprises one or more additional powers of one or more of said intensity asymmetry metrics.

8. A method as claimed in any preceding claim, wherein said step of determining a value for a parameter of interest comprises determining a linear sum of said phase difference metric data and said intensity asymmetry metric data as weighted by said pre-calibrated asymmetry coefficients.

9. A method as claimed in any preceding claim, comprising an initial calibration step for calibrating said asymmetry coefficients, the initial calibration step comprising:

   obtaining calibration metrology data relating to a plurality of targets on at least one calibration substrate, the calibration metrology data comprising intensity metric data relating to said intensity metrics, and said phase difference metric data;
   determining calibration intensity asymmetry metric data from said intensity metric data, said calibration intensity asymmetry metric data describing, for each said intensity metric, an asymmetry in said intensity metric data between diffraction orders of a complementary pair of diffraction orders following diffraction by said targets;
   obtaining reference data relating to said parameter of interest; and
   optimizing said one or more asymmetry coefficients so as to minimize a difference between said reference data and said uncorrected parameter of interest data when corrected with a combination of said calibration intensity asymmetry metric data and said asymmetry coefficients.

10. A method as claimed in claim 9, wherein said optimizing step comprises minimizing a merit function relating said reference data to said uncorrected parameter of interest data and said calibration intensity asymmetry metric data as weighted by said asymmetry coefficients.

11. A method as claimed in any of claims 9 to 10, further comprising calibrating one or more model term coefficients, each model term coefficient corresponding to a respective model term describing a function of substrate location which is independent of the parameter of interest.

12. A method as claimed in any of claims 9 to 11, comprising applying at least one filter term to the calibration intensity asymmetry metric data prior to or as part of the optimization step.

13. A method as claimed in any preceding claim, wherein said one or more pre-calibrated asymmetry coefficients comprise location or region dependent pre-calibrated asymmetry coefficients and/or context dependent pre-calibrated asymmetry coefficients.

14. A method as claimed in any preceding claim, comprising determining a process correction based on said value for a parameter of interest.

Fig. 1

Fig. 2

Fig. 3

Fig. 4

Fig. 5

Fig. 6

Fig. 7

Europäisches
Patentamt

European
Patent Office

Office européen
des brevets

# EUROPEAN SEARCH REPORT

Application Number

EP 23 17 0059

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "METROLOGY METHOD AND ASSOCIATED METROLOGY DEVICE", RESEARCH DISCLOSURE, KENNETH MASON PUBLICATIONS, HAMPSHIRE, UK, GB , vol. 695, no. 61 1 February 2022 (2022-02-01), XP007150053, ISSN: 0374-4353 Retrieved from the Internet: URL:https://www.researchdisclosure.com/database/RD695061 [retrieved on 2022-02-09] * paragraphs [0050] - [0059], [0063] - [0069] * ----- | 1-14 | INV. G03F7/00 |
| A | US 2022/035257 A1 (GOORDEN SEBASTIANUS ADRIANUS [NL] ET AL) 3 February 2022 (2022-02-03) * paragraphs [0103] - [0113] * ----- | 1-14 | |
| A | WO 2022/122546 A1 (ASML NETHERLANDS BV [NL]) 16 June 2022 (2022-06-16) * paragraphs [0058] - [0071] * ----- | 1-14 | TECHNICAL FIELDS SEARCHED (IPC) G03F |

The present search report has been drawn up for all claims

| Place of search | Date of completion of the search | Examiner |
|---|---|---|
| Munich | 9 October 2023 | Roesch, Guillaume |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 17 0059

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2023

| Patent document cited in search report | | | Publication date | Patent family member(s) | | | Publication date |
|---|---|---|---|---|---|---|---|
| US 2022035257 | A1 | | 03-02-2022 | CN | 112740109 | A | 30-04-2021 |
| | | | | EP | 3853666 | A1 | 28-07-2021 |
| | | | | IL | 281502 | A | 29-04-2021 |
| | | | | JP | 7169435 | B2 | 10-11-2022 |
| | | | | JP | 2022500685 | A | 04-01-2022 |
| | | | | KR | 20210043661 | A | 21-04-2021 |
| | | | | NL | 2023709 | A | 30-04-2020 |
| | | | | TW | 202028874 | A | 01-08-2020 |
| | | | | US | 2022035257 | A1 | 03-02-2022 |
| | | | | WO | 2020057900 | A1 | 26-03-2020 |
| WO 2022122546 | A1 | | 16-06-2022 | CN | 116569111 | A | 08-08-2023 |
| | | | | IL | 303221 | A | 01-07-2023 |
| | | | | KR | 20230113565 | A | 31-07-2023 |
| | | | | TW | 202240302 | A | 16-10-2022 |
| | | | | WO | 2022122546 | A1 | 16-06-2022 |

EPO FORM P0459

For more details about this annex : see Official Journal of the European Patent Office, No. 12/82

## REFERENCES CITED IN THE DESCRIPTION

**Patent documents cited in the description**

- WO 2009078708 A
- WO 2009106279 A
- US 20110027704 A

- US 20110043791 A
- US 20120242940 A
- WO 2022008135 A1

**Non-patent literature cited in the description**

- **MATSUNOBU et al.** Novel diffraction-based overlay metrology utilizing phase-based overlay for improved robustness. *Proc. SPIE 11611, Metrology, Inspection, and Process Control for Semiconductor Manufacturing,* 22 February 2021, vol. XXXV, 1161126